# EUROPEAN PATENT APPLICATION

(11) **EP 4 822 517 A1**
(43) Date of publication of application: **14.10.2026**
(21) Application number: 24910976.0
(22) Date of filing: 20.12.2024
(51) Int. Cl.: G06F 7/483, G06F 7/499, H03M 7/24

(54) **FLOATING POINT NUMBER PROCESSING METHOD, APPARATUS, COMPUTING DEVICE AND STORAGE MEDIUM**

(30) Priority: 25.12.2023 CN 202311811917
(71) Applicant: Huawei Technologies Co., Ltd., Shenzhen, Guangdong 518129 (CN)
(72) Inventor: LUO, Yuanyong, Shenzhen, Guangdong 518129 (CN); ZHANG, Zhongxing, Shenzhen, Guangdong 518129 (CN); HU, Guipeng, Shenzhen, Guangdong 518129 (CN); HU, Tianchi, Shenzhen, Guangdong 518129 (CN)
(74) Representative: Pfenning, Meinig & Partner mbB
(86) International application number: PCT/CN2024/141099
(87) International publication number: WO 2025/140047

(57) **Abstract**

This application, related to the field of computer technologies, discloses a floating-point number processing method and apparatus, a compute device, and a storage medium. The compute device obtains a first floating-point number, and decodes the first floating-point number to obtain a sign, an exponent, and a mantissa. The first floating-point number may include a first sign field, a bit width indication field, a first exponent field, and a first mantissa field. The bit width indication field indicates a bit width D occupied by the first exponent field in a total bit width N of the first floating-point number. When the total bit width is fixed, the bit width of the first exponent field and a bit width of the first mantissa field may dynamically change with a value indicated by the bit width indication field. The bit width indication field may further indicate that the first mantissa field represents the mantissa or a bias of the exponent. Reusing the first mantissa field can ensure that precision of the floating-point number is slightly affected, and can increase coding space of the exponent, thereby achieving a larger dynamic range of a value represented by the floating-point number, and satisfying requirements of AI training and inference.

## Description

### CROSS-REFERENCE TO RELATED APPLICATIONS

This application claims priority to Chinese Patent Application No. 202311811917.5, filed with the China National Intellectual Property Administration on December 25, 2023 and entitled "FLOATING-POINT NUMBER PROCESSING METHOD AND APPARATUS, COMPUTE DEVICE, AND STORAGE MEDIUM", which is incorporated herein by reference in its entirety.

### TECHNICAL FIELD

This application relates to the field of computer technologies, and in particular, to a floating-point number processing method and apparatus, a compute device, and a storage medium.

### BACKGROUND

In a computer system, a floating point (floating point, FP) is an approximate numerical representation of a real number, and is also referred to as a floating-point data representation. For example, floating-point data representations may include FP8, FP16, and FP32. FP8 represents an 8-bit floating-point number, FP16 represents a 16-bit floating-point number, and FP32 represents a 32-bit floating-point number. Generally, a floating-point number includes three fields: a sign (sign) field, an exponent (exponent) field, and a mantissa (mantissa) field respectively. In each of the floating-point data representations, a bit width of each field is fixed. For example, FP16 includes a 1-bit (bit) sign field, a 5-bit exponent field, and a 10-bit mantissa field; FP32 includes a 1-bit sign field, an 8-bit exponent field, and a 23-bit mantissa field; and FP8 may include two types, where one type includes a 1-bit sign field, a 5-bit exponent field, and a 2-bit mantissa field, and the other type includes a 1-bit sign field, a 4-bit exponent field, and a 3-bit mantissa field. The bit width of the exponent field determines a value range that can be represented by the floating-point number, and the bit width of the mantissa field determines numerical precision that can be represented by the floating-point number.

With rapid development of artificial intelligence (artificial intelligence, AI) mixed precision training and inference, floating-point numbers are increasingly employed in mixed precision training. As the scale of AI network parameters increases sharply, using a floating-point number with a smaller bit width for AI training and inference can reduce data storage and data transfer overheads.

However, a smaller overall bit width of a floating-point number indicates a smaller bit width of an exponent field of the floating-point number, and a smaller value range that can be represented. In this case, requirements of AI training and inference usually cannot be satisfied, and performance of AI training and inference is affected.

### SUMMARY

Embodiments of this application provide a floating-point number processing method and apparatus, a compute device, and a storage medium, to achieve a larger dynamic range of a value represented by a floating-point number, and satisfy requirements of AI training and inference.

According to a first aspect, an embodiment of this application provides a floating-point number processing method. The method may be performed by a compute device, or may be performed by a chip, a chip system, or a circuit in a compute device. The floating-point number processing method may include: The compute device obtains a first floating-point number, where the first floating-point number may include a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number; and after obtaining the first floating-point number, the compute device may decode the first floating-point number to obtain the sign, the exponent, and the mantissa.

In this embodiment of this application, in addition to the first sign field, the first exponent field, and the first mantissa field, the first floating-point number may further include the bit width indication field. The bit width indication field indicates the bit width D occupied by the first exponent field in the total bit width N of the floating-point number. On a premise that the total bit width is fixed, the bit width of the first exponent field and a bit width of the first mantissa field may dynamically change with a value indicated by the bit width indication field, thereby satisfying requirements for different value ranges and precision of the floating-point number in different scenarios. The bit width indication field may further indicate that the first mantissa field represents the mantissa or the bias of the exponent. In other words, the first mantissa field may represent the mantissa, or may indicate the exponent. Reusing the first mantissa field can ensure that the precision of the floating-point number is slightly affected, and can increase coding space of the exponent, thereby achieving a larger dynamic range of a value represented by the floating-point number, and satisfying requirements of AI training and inference.

In an optional implementation, after obtaining the first floating-point number, the compute device may decode the first floating-point number to obtain a second floating-point number. The second floating-point number may include a second sign field, a second exponent field, and a second mantissa field, the second sign field indicates the sign, the second exponent field indicates the exponent, and the second mantissa field indicates the mantissa.

In an optional implementation, when the bit width D of the first exponent field of the first floating-point number is not 0, the mantissa may be a value indicated by the first mantissa field, and the exponent may be a value indicated by the first exponent field; or when the bit width D of the first exponent field of the first floating-point number is 0, the first exponent field does not exist. In this case, if the first mantissa field represents the mantissa, the exponent may be a first preset exponent. If the first mantissa field represents the bias of the exponent, the exponent is a value obtained by correcting a second preset exponent by using the bias, and the mantissa may be a preset mantissa.

In the implementation, when the first exponent field does not exist, if the first mantissa field represents the mantissa, the exponent may be the first preset exponent; or if the first mantissa field represents the bias of the exponent, the exponent is the value obtained by correcting the second preset exponent by using the bias. The value obtained by correcting the second preset exponent by using the bias and the value indicated by the first exponent field belong to different value ranges. For example, when the total bit width of the first floating-point number is 8, a value range to which the value indicated by the first exponent field belongs may be [-15, 15], and a value range to which the value obtained by correcting the second preset exponent by using the bias belongs may be [-22, -16]. Therefore, an exponent value range that can be represented by the first floating-point number may reach [-22, 15]. Compared with a dynamic range of a value that can be represented by an 8-bit floating-point number representation in a related technology, the larger dynamic range of the value represented by the floating-point number is achieved.

In an optional implementation, a bit width DW of the bit width indication field is negatively correlated with the bit width D of the first exponent field. When the total bit width of the first floating-point number is fixed, a jump of the bit width of the first mantissa field caused by simultaneous increases of the bit widths of the bit width indication field and the first exponent field can be avoided. The bit width of the mantissa field determines precision of floating-point data. Therefore, in this implementation, precision of the value represented by the first floating-point number can be smoothly changed, thereby avoiding a jump of the precision of the value represented by the first floating-point number.

In an optional implementation, when the bit width DW of the bit width indication field is a preset bit width, and a value indicated by the bit width indication field is a preset value, the first mantissa field represents the bias. For example, in an embodiment, when the total bit width of the first floating-point number is 8, and the bit width DW of the bit width indication field is 4, if the value of the bit width indication field is "0000", it indicates that the first mantissa field represents the bias; or when the total bit width of the first floating-point number is 8, and the bit width DW of the bit width indication field is 4, if the value of the bit width indication field is "0001", it indicates that the first mantissa field represents the bias.

In an optional implementation, the compute device may read the first floating-point number from a memory, or obtain the first floating-point number over a communication network. After the first floating-point number is decoded to obtain the sign, the exponent, and the mantissa, computation may be performed by using the obtained sign, exponent, and mantissa.

In a related technology, when a total bit width of a floating-point number is determined, bit widths of an exponent field and a mantissa field of the floating-point number are always fixed. When a computational process requires higher precision or a larger value range, selecting a data format with a larger total bit width is required. However, an increase in the total bit width means that both the bit width of the exponent field and the bit width of the mantissa field increase. As a result, when only higher precision is required, the increased bit width of the exponent field is wasted, and when only a larger value range is required, the increased bit width of the mantissa field is wasted. Consequently, unnecessary storage space is occupied, and data storage and data transfer overheads of the floating-point number are increased. In this embodiment of this application, the first floating-point number may be used for data storage or data transfer. Because the bit widths of the first exponent field and the first mantissa field of the first floating-point number can dynamically change with the value indicated by the bit width indication field, different requirements for a value range and value precision of the floating-point number in various scenarios can be flexibly satisfied without additionally increasing the total bit width of the floating-point number, that is, without additionally increasing data storage or data transfer costs.

According to a second aspect, an embodiment of this application provides a floating-point number processing method. The method may be performed by a compute device, or may be performed by a chip, a chip system, or a circuit in a compute device. The floating-point number processing method may include: The compute device obtains a sign, an exponent, and a mantissa, and obtaining a first floating-point number based on the sign, the exponent, and the mantissa. The first floating-point number includes a first sign field, a bit width indication field, a first exponent field, and a first mantissa field, the first sign field indicates a sign of the first floating-point number, and the bit width indication field indicates a bit width D occupied by the first exponent field in a total bit width N of the first floating-point number. The bit width indication field further indicates that the first mantissa field represents a mantissa of the first floating-point number or a bias of an exponent of the first floating-point number.

In an optional implementation, when the bit width D of the first exponent field is 0, the first exponent field does not exist, and if the first mantissa field represents the mantissa, the exponent is a first preset exponent.

In an optional implementation, when the bit width D of the first exponent field is 0, the first exponent field does not exist, and if the first mantissa field represents the bias of the exponent, the mantissa is a preset mantissa, and the exponent is a value obtained by correcting a second preset exponent by using the bias.

In an optional implementation, when the bit width D of the first exponent field is not 0, the first mantissa field represents the mantissa, and the exponent is a value indicated by the first exponent field.

In an optional implementation, a bit width DW of the bit width indication field is negatively correlated with the bit width D.

In an optional implementation, when the bit width DW of the bit width indication field is a preset bit width, and a value indicated by the bit width indication field is a preset value, the first mantissa field represents the bias of the exponent.

According to a third aspect, an embodiment of this application provides a floating-point number processing apparatus. The apparatus may be applied to a compute device. The floating-point number processing apparatus may include:
a floating-point number obtaining module, configured to obtain a first floating-point number, where the first floating-point number includes a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number; and
a decoding module, configured to decode the first floating-point number to obtain the sign, the exponent, and the mantissa.

In an optional implementation, the decoding module may be specifically configured to:
decode the first floating-point number to obtain a second floating-point number, where the second floating-point number includes a second sign field, a second exponent field, and a second mantissa field, the second sign field indicates the sign, the second exponent field indicates the exponent, and the second mantissa field indicates the mantissa.

In an optional implementation, when the bit width D is 0, the first exponent field does not exist, and if the first mantissa field represents the mantissa, the exponent is a first preset exponent.

In an optional implementation, when the bit width D is 0, the first exponent field does not exist, and if the first mantissa field represents the bias, the mantissa is a preset mantissa, and the exponent is a value obtained by correcting a second preset exponent by using the bias.

In an optional implementation, when the bit width D is not 0, the first mantissa field represents the mantissa, and the exponent is a value indicated by the first exponent field.

In an optional implementation, a bit width DW of the bit width indication field is negatively correlated with the bit width D.

In an optional implementation, when the bit width DW of the bit width indication field is a preset bit width, and a value indicated by the bit width indication field is a preset value, the first mantissa field represents the bias.

In an optional implementation, the floating-point number obtaining module may be specifically configured to:
read the first floating-point number from a memory, or obtain the first floating-point number over a communication network.

In an optional implementation, the floating-point number processing apparatus may further include a compute module, and the compute module may be configured to perform computation by using the sign, the exponent, and the mantissa.

According to a fourth aspect, an embodiment of this application provides a floating-point number processing apparatus. The apparatus may be applied to a compute device. The floating-point number processing apparatus may include:
a data obtaining module, configured to obtain a sign, an exponent, and a mantissa; and
an encoding module, configured to obtain a first floating-point number based on the sign, the exponent, and the mantissa, where the first floating-point number includes a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number.

In an optional implementation, when the bit width D is 0, the first exponent field does not exist, and if the first mantissa field represents the mantissa, the exponent is a first preset exponent.

In an optional implementation, when the bit width D is 0, the first exponent field does not exist, and if the first mantissa field represents the bias, the mantissa is a preset mantissa, and the exponent is a value obtained by correcting a second preset exponent by using the bias.

In an optional implementation, when the bit width D is not 0, the first mantissa field represents the mantissa, and the exponent is a value indicated by the first exponent field.

In an optional implementation, a bit width DW of the bit width indication field is negatively correlated with the bit width D.

In an optional implementation, when the bit width DW of the bit width indication field is a preset bit width, and a value indicated by the bit width indication field is a preset value, the first mantissa field represents the bias.

According to a fifth aspect, an embodiment of this application provides a compute device. The compute device includes a processor and a memory. The memory stores a computer program. The processor is configured to read the computer program stored in the memory and perform any floating-point number processing method according to the first aspect or the second aspect.

According to a sixth aspect, an embodiment of this application provides a computer-readable storage medium, storing computer-executable instructions. The computer-executable instructions are used to enable a computer to perform any floating-point number processing method according to the first aspect or the second aspect.

According to a seventh aspect, an embodiment of this application provides a computer program product, including computer-executable instructions. The computer-executable instructions are used to enable a computer to perform any floating-point number processing method according to the first aspect or the second aspect.

For technical effect that can be achieved in any one of the second aspect to the seventh aspect, refer to descriptions of beneficial effect in the first aspect. Details are not described herein again.

### BRIEF DESCRIPTION OF DRAWINGS

FIG. 1 is a diagram of an application scenario according to an embodiment of this application;
FIG. 2 is a diagram of a structure of a compute device according to an embodiment of this application;
FIG. 3 is a diagram of a distribution between a significand and an exponent of a floating-point number according to an embodiment of this application;
FIG. 4 is a flowchart of a floating-point number processing method according to an embodiment of this application;
FIG. 5 is a diagram of decoding a first floating-point number by a decoder according to an embodiment of this application;
FIG. 6 is a flowchart of another floating-point number processing method according to an embodiment of this application;
FIG. 7 is a diagram of encoding a first floating-point number by an encoder according to an embodiment of this application;
FIG. 8 is a flowchart of another floating-point number processing method according to an embodiment of this application;
FIG. 9 is a diagram of training effect of performing AI training by using a floating-point number in a related technology;
FIG. 10 is a diagram of training effect of performing AI training by using a floating-point number according to an embodiment of this application;
FIG. 11 is a diagram of a structure of a floating-point number processing apparatus according to an embodiment of this application;
FIG. 12 is a diagram of a structure of another floating-point number processing apparatus according to an embodiment of this application; and
FIG. 13 is a diagram of a structure of a compute device according to an embodiment of this application.

### DESCRIPTION OF EMBODIMENTS

To make objectives, technical solutions, and advantages of embodiments of this application clearer, the following describes embodiments of this application in detail with reference to accompanying drawings. Terms used in implementations of this application are merely for explaining specific embodiments of this application, but are not intended to limit this application.

Before specific solutions provided in embodiments of this application are described, some terms in this application are explained and described, to facilitate understanding by a person skilled in the art, but not to limit the terms in this application.
(1) Integer (integer) coding refers to fixed-length binary coding on an integer, for example, 3-bit (bit) binary coding on 0 to 7, and 4-bit binary coding on 0 to 15.
(2) Prefix code (prefix code) coding may also be referred to as prefix coding. If in a coding scheme, no code is a prefix (leftmost substring) of any other code, the coding scheme may be referred to as prefix coding. For example, unequal-length codes: 1, 01, 001, 0101; or 00, 01, 10, 1100, 1101; and equal-length codes: 00, 01, 10, 11, and the like all belong to prefix coding. Prefix coding can ensure no ambiguity during decoding of a compressed file, thereby ensuring correct decoding.

Prefix coding may include conventional prefix coding and unconventional prefix coding. Conventional prefix coding uses a shorter bit width to code smaller data and a longer bit width to code larger data. Conversely, unconventional prefix coding uses a shorter bit width to code larger data and a longer bit width to code smaller data. In some embodiments of this application, unconventional prefix coding may be performed on a Dot field in a floating-point number. For details, refer to descriptions in the following embodiments.

In embodiments of this application, "a plurality of" means two or more. In view of this, in embodiments of this application, "a plurality of" may also be understood as "at least two". "At least one" may be understood as one or more, for example, one, two, or more. For example, "include at least one" means "include one, two, or more", and there is no limitation on which is included. For example, "include at least one of A, B, and C" may mean "include A, B, or C", "include A and B, A and C, or B and C", or "include A, B, and C". The term "and/or" describes an association relationship for describing associated objects and represents that three relationships may exist. For example, A and/or B may represent the following three cases: Only A exists, both A and B exist, and only B exists. In addition, the character "/" generally indicates an "or" relationship between the associated objects.

Unless otherwise specified, ordinal numbers such as "first" and "second" in embodiments of this application are used to distinguish between a plurality of objects, and are not intended to limit a sequence, a time sequence, priorities, or importance of the plurality of objects.

A floating-point data representation is a scientific computation method. In the institute of electrical and electronics engineers (institute of electrical and electronics engineers, IEEE) 754 binary floating-point number standard, a floating-point number may include three fields: a sign (sign) field, an exponent (exponent) field, and a mantissa (mantissa) field. A value of the exponent field represents an integer exponent of a specific base, and a value of the mantissa field can be multiplied by an integer exponent of a specific base to obtain a piece of data. The sign field indicates that the data is positive or negative. For example, binary data 100.101 (that is, decimal data 4.625) is used as an example. The data may be represented as (-1)⁰×2²×1.00101, where the exponent 0 of the base -1 is a value of a sign field in the floating-point number, and indicates that the data is positive or negative. The exponent 2 of the base 2 is a value of an exponent field in the floating-point number, and indicates a quantity of decimal point shifts. For example, from 100.101 to 1.00101, the quantity of decimal point shifts is 2. 1.00101 is a mantissa. Because a value before the decimal point is required to be 1, a value actually stored in the mantissa field of the floating-point number can include only the data after the decimal point, that is, 00101. In this way, one binary bit can be saved to store more mantissas.

For example, common floating-point data representations may include FP16 and FP32, where FP16 represents a 16-bit floating-point number, and FP32 represents a 32-bit floating-point number. In each of the floating-point data representations, a bit width of each field is fixed. For example, FP16 includes a 1-bit sign field, a 5-bit exponent field, and a 10-bit mantissa field; and FP32 includes a 1-bit sign field, an 8-bit exponent field, and a 23-bit mantissa field. The bit width of the exponent field determines a value range that can be represented by the floating-point number, and the bit width of the mantissa field determines numerical precision that can be represented by the floating-point number.

As the scale of AI network parameters increases sharply, using a floating-point number with a smaller bit width for AI training and inference can reduce data storage and data transfer overheads. As a result, FP8 floating-point numbers emerge, and there are two types of FP8 floating-point numbers. For details, refer to Table 1.

**Table 1**

| | Sign | Exponent | Mantissa |
|---|---|---|---|
| E5M2 | 1 bit | 5 bits | 2 bits |
| E4M3 | 1 bit | 4 bits | 3 bits |

As shown in Table 1, there are two types of FP8 floating-point numbers: E5M2 and E4M3. The E5M2 floating-point number includes a 1-bit sign field, a 5-bit exponent field, and a 2-bit mantissa field. The E4M3 floating-point number includes a 1-bit sign field, a 4-bit exponent field, and a 3-bit mantissa field. A bit width of an exponent field in a floating-point number determines an exponent range that can be represented by the floating-point number. An exponent range that can be represented by an E5M2 floating-point number is [-16, 15], and an exponent range that can be represented by an E4M3 floating-point number is smaller, that is, [-9, 8].

Dynamic ranges of values that can be represented by the two types of FP8 floating-point numbers are small, and usually cannot satisfy requirements of AI training and inference, affecting performance of AI training and inference. However, when a conventional floating-point data representation is used, only a data format with a larger total bit width can be selected, for example, an FP16 floating-point number or an FP32 floating-point number. This may easily cause a waste of a bit width of an exponent field or a bit width of a mantissa field in a floating-point number with a larger total bit width, causing the floating-point number to occupy unnecessary storage space, and greatly increasing data storage and data transfer overheads of the floating-point number.

Based on this, embodiments of this application provide a floating-point number processing method. The floating-point number provided in embodiments of this application may further include a bit width indication field (that is, a Dot field), a first exponent field, and a first mantissa field in addition to a first sign field. The Dot field indicates a bit width D occupied by the first exponent field in a total bit width N of the floating-point number. When the bit width D is not 0, the first exponent field indicates an exponent of the floating-point number, and the first mantissa field indicates a mantissa of the floating-point number. Under the same total bit width, the bit width of the first exponent field and a bit width of the first mantissa field may dynamically change with a value of the Dot field, to satisfy requirements for different value ranges and precision of the floating-point number in different scenarios. When the bit width D is 0, the Dot field may further indicate that the first mantissa field represents the mantissa of the floating-point number or a bias of the exponent of the floating-point number. Reusing the first mantissa field can ensure that precision of the floating-point number is slightly affected, and can increase coding space of the exponent, thereby achieving a larger dynamic range of a value represented by the floating-point number. For example, a floating-point number whose total bit width N is 8 is used as an example. A dynamic range of a value represented by the E4M3 floating-point number is [-9, 8], a dynamic range of a value that can be represented by the E5M2 floating-point number is [-16, 15], and a dynamic range of a value that can be represented by the HiF8_DML floating-point number provided in embodiments of this application is [-22, 15]. In this way, a much larger dynamic range of a value represented by the floating-point number can be achieved, and requirements of AI training and inference can be satisfied.

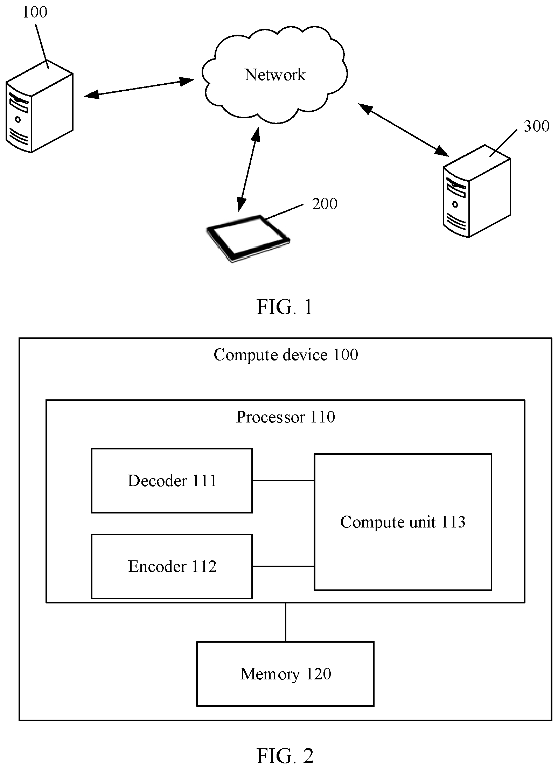

The floating-point number processing method provided in embodiments of this application may be applied to a compute device, and is widely applicable to various industries such as scientific research, engineering, finance, aerospace, and healthcare, which need to store, compute, and transmit a large amount of data every day. FIG. 1 is a diagram of an example of an application scenario according to an embodiment of this application. As shown in FIG. 1, in the application scenario, a compute device 100, a compute device 200, and a compute device 300 may establish a communication connection over a network. The network may be a wired network, or may be a wireless network, for example, a wireless fidelity (wireless fidelity, Wi-Fi), Bluetooth, or mobile network. The compute device 100, the compute device 200, and the compute device 300 may be any electronic devices such as computers, servers, intelligent wearable devices, smart home devices, tablet computers, notebook computers, vehicle-mounted terminals, or smartphones. When the compute device is a server, the compute device may be one server, or may be a server cluster including a plurality of servers, or may be a cloud computing service center, or the like. The communication connection is established between the compute device 100, the compute device 200, and the compute device 300, and floating-point number-based data storage, computation, transmission, and the like may be performed.

It should be noted that, in an actual application scenario, the system may include more than three compute devices, or may include less than three compute devices. This is not limited in this application.

Internal structures of the compute device 100, the compute device 200, and the compute device 300 may be the same. The compute device 100 is used as an example for description, as shown in FIG. 2. The compute device 100 may include a processor 110 and a memory 120. For example, the processor 110 may be but is not limited to a chip, for example, a central processing unit (central processing unit, CPU), a high-performance computing (high performance computing, HPC) service acceleration chip, a graphics processing unit (graphics processing unit, GPU), or an embedded neural network processing unit (neural network processing unit, NPU) in the AI field. The processor 110 may include a decoder (decoder) 111, an encoder (encoder) 112, and a compute unit 113. There may be one or more compute units 113.

For example, the processor 110 may include a part or all of the following compute units: a scalar compute unit, a vector compute unit, a matrix compute unit, or a tensor compute unit.

The following separately describes different compute units.
1. Scalar compute unit: A scalar, also referred to as a pure number, has only a magnitude and no direction. A circuit for scalar computation is referred to as a scalar compute unit. Scalar computation is mainly used for general-purpose computation. In embodiments of this application, an arithmetic logic unit ALU (Arithmetic Logic Unit) based on the HiF8_DML data format may be embedded in an execution unit (execution unit, EXU) part of a CPU multilevel pipeline or a scalar compute part of another processor with a similar function.
2. Vector compute unit: A vector usually refers to a one-dimensional array whose length is greater than 1. A compute unit specially designed for vector computation and with a specific degree of parallelism is referred to as a vector compute unit, for example, a single instruction multiple data (single instruction multiple data, SIMD) processor. The vector compute unit is mainly used in the fields of HPC high performance computing, AI machine learning, and the like, for example, linear programming, Fourier transform, filter computation, and solving of mathematical problems such as linear algebra, partial differential equations, and integrals. In embodiments of this application, an arithmetic execution unit (vector unit) based on the HiF8_DML data format may be embedded in a vector compute acceleration unit or a vector processor.
3. Matrix compute unit: A matrix is a two-dimensional array arranged in a rectangular array. A compute unit specially designed for matrix computation and with a corresponding degree of parallelism is referred to as a matrix compute unit, for example, a systolic array (systolic array) processor. The matrix compute unit is mainly used for matrix computation in fields such as HPC high performance computing and AI machine learning, including matrix multiplication, matrix inversion, and matrix factorization. In embodiments of this application, a matrix unit (matrix unit) based on the HiF8_DML data format may be embedded in a matrix compute acceleration unit.
4. Tensor compute unit: A tensor is a multidimensional array with more than two dimensions, and a common tensor is a three-dimensional array. A compute unit specially designed for tensor computation and with a corresponding degree of parallelism is referred to as a tensor compute unit. The tensor compute unit is mainly used in the field of AI machine learning, for example, a convolution operation. In embodiments of this application, a tensor unit (tensor unit) based on the HiF8_DML data format may be embedded in a tensor compute acceleration unit.

For example, when the compute device 100 performs general-purpose computation, high-performance computing, or AI training, a large amount of floating-point data needs to be used. In this case, the compute device 100 may decode an obtained floating-point number via the decoder 111 by using the floating-point number processing method provided in embodiments of this application, to obtain decoded data. For example, the floating-point number may be read from the local memory 120 of the compute device 100, or may be obtained from the compute device 200 or the compute device 300 over the network, or may be obtained from another device in the network. After decoding the obtained floating-point number to obtain the decoded data, the decoder 111 may transmit the decoded data to the compute unit 113, to complete corresponding computation via the compute unit 113. The compute unit 113 transmits a computational result to the encoder 112, and the encoder 112 re-encodes the computational result into a floating-point number. The floating-point number may be used for data storage and data transfer. For example, the processor 110 may store, in the memory 120, the floating-point number obtained through encoding by the encoder 112.

Optionally, for specific structures and functions of the compute device 200 and the compute device 300 in FIG. 1, refer to the compute device 100 shown in FIG. 2. In some possible embodiments, the compute device 100, the compute device 200, and the compute device 300 may include more or fewer components than those shown in FIG. 2. This is not specifically limited in embodiments of this application.

For ease of understanding, the following first describes a data format of a floating-point number provided in an embodiment of this application. Table 2 shows a data format of a floating-point number provided in an embodiment of this application.

**Table 2**

| Field (Region) | First sign (Sign) field | Dot field | First exponent field | First mantissa field |
|---|---|---|---|---|
| Bit width (Width)/bit | 1 | DW | D | N-1-DW-D |

As shown in Table 2, the floating-point number provided in this embodiment of this application may include a first sign field, a Dot field, a first exponent field, and a first mantissa field. The Dot field indicates a bit width D occupied by the first exponent field in a total bit width N of the floating-point number. N is an integer greater than 1, and D is an integer greater than or equal to 0. The following embodiment uses an example in which the binary system is used and a total bit width N of a floating-point number is 8 for description. First, each field of the floating-point number is described in detail with reference to Table 2 and Table 3.

**Table 3**

| Field (Region) | First sign (Sign) field | Dot field | First exponent field | First mantissa field |
|---|---|---|---|---|
| | | Bit width DW: values (Values) | Bit width D: values (Values) | Bit width |
| | Bit width | | | |
| | 1 | 2:[2, 3, 4] | D:±[2, 15] | 5-D |
| | 1 | 3:1 | D:±1 | 4-D |
| | 1 | 4:0 | D:0 | 3-D |
| | 1 | 4:DML | | 3 |

1. First sign field: The first sign field may also be referred to as a sign bit. As shown in Table 3, the sign field is located before the Dot field, occupies 1 bit in the total bit width N of the floating-point number, and indicates that the data is positive or negative. By default, 0 indicates positive, and 1 indicates negative. Alternatively, 0 may indicate negative and 1 may indicate positive based on an actual requirement. This is not limited in this application.
2. Dot field: occupies DW bits in the total bit width N of the floating-point number, where a value of DW ranges from 2 to 4. A value (or a coded value) represented by the Dot field indicates a bit width D occupied by the first exponent field in the total bit width N of the floating-point number, that is, the value of the Dot field is D. When D is not 0, the first exponent field indicates an exponent of the floating-point number; and the first mantissa field indicates a mantissa of the floating-point number. When the bit width D is 0, the bit width field may further indicate that the first mantissa field represents the mantissa of the floating-point number or a bias of the exponent of the floating-point number.

Optionally, prefix coding may be used for coding the Dot field. Prefix coding may include conventional prefix coding and unconventional prefix coding. Conventional prefix coding uses a shorter bit width to represent a smaller value and a longer bit width to represent a larger value. Conversely, unconventional prefix coding uses a shorter bit width to represent a larger value and a longer bit width to represent a smaller value.

In some embodiments, the Dot field may be coded by using an unconventional prefix coding scheme, that is, a longer bit width is used to represent a smaller value, and a shorter bit width is used to represent a larger value. For example, when the bit width DW is a first bit width value, D1 values are coded by using a bit width DW1 occupied by the Dot field, and a bit width D of a first value field belongs to any one of the D1 values; or when the bit width DW is a second bit width value, D2 values are coded by using a bit width DW2 occupied by the Dot field, and a bit width D of the first value field belongs to any one of the D2 values. DW1 is less than DW2, and a smallest value in the D1 values is greater than a largest value in the D2 values. D1 and D2 are integers greater than or equal to 0.

For example, the Dot field occupies 2 to 4 bits in the total bit width N of the floating-point number, that is, the bit width (width) of the Dot field is 2 to 4. A specific coding scheme may be shown in Table 4.

**Table 4**

| Bit width (Width) | Code (Coding) | Value (Value) |
|---|---|---|
| 2 | 11 | 4 |
| | 10 | 3 |
| | 01 | 2 |
| 3 | 001 | 1 |
| 4 | 0001 | 0 |
| | 0000 | DML |

As shown in Table 4, when the bit width of the Dot field is 2, a 2-bit width may be used for coding to represent any one of three values 2, 3, and 4. For example, the code (coding) "11" may represent the value (value) "4", the code "10" may represent the value "3", and the code "01" may represent the value "2". When the bit width of the Dot field is 3, a 3-bit width may be used for coding to represent a value 1. For example, the code "001" may represent the value "1". The values 1, 2, 3, and 4 indicate the bit width D of the first exponent field, and the first exponent field represents the exponent of the floating-point number. When the bit width of the Dot field is 4, a 4-bit width may be used for coding to represent a value 0. In this case, the first exponent field does not exist.

The unconventional prefix coding is used for a bit width indication field, and a bit width DW of the bit width indication field is negatively correlated with a value indicated by the bit width indication field. In other words, the bit width DW of the bit width indication field is negatively correlated with the bit width D of the first exponent field. When the total bit width of the floating-point number is fixed, a jump of the bit width of the first mantissa field caused by simultaneous increases of the bit widths of the bit width indication field and the first exponent field can be avoided. The bit width of the mantissa field determines precision of floating-point data. Therefore, precision of the value represented by the first floating-point number can be smoothly changed, thereby avoiding a jump of the precision of the value represented by the first floating-point number. Especially when the exponent is near an exponent center, the jump of the bit width of the mantissa field can be smoothed, that is, the jump of the precision of the value near the exponent center can be smoothed.

When the bit width of the Dot field is 4, the Dot field further indicates that the first mantissa field represents the mantissa of the floating-point number or a bias of the exponent of the floating-point number. For example, in an embodiment, the code "0001" may represent the value "0". In this case, the bit width D of the first exponent field is 0 bits, and the first mantissa field represents the mantissa of the floating-point number. The code "0000" may represent that the floating-point number is DML data. The DML data refers to a value that is lower than a normal number (subnormal) or a value that is an abnormal number (denormal). In this case, the first mantissa field represents the bias of the exponent of the floating-point number. In other words, when the bit width of the Dot field is 4, if the Dot field is a preset value "0000", the Dot field indicates that the floating-point number is DML data, or indicates that the first mantissa field represents the bias of the exponent of the floating-point number. In another embodiment, the code "0000" may alternatively represent the value "0". In this case, the bit width D of the first exponent field is 0 bits, and the first mantissa field represents the mantissa of the floating-point number. The code "0001" may represent that the floating-point number is DML data, that is, the Dot field is a preset value "0001". In this case, the Dot field indicates that the floating-point number is DML data, or indicates that the first mantissa field represents the bias of the exponent of the floating-point number. It can be learned from the foregoing description that the bit width indication field may be described as Dot=[0, 4]&DML, indicating that in addition to the DML flag, a value D represented by the code of the bit width indication field ranges from 0 to 4, and the bit width indication field indicates the bit width D occupied by the first exponent field in the total bit width N of the floating-point number. In other words, the bit width D of the first exponent field ranges from 0 to 4 bits.

3. First exponent field: represents the exponent of the floating-point number, where the bit width occupied in the total bit width N of the floating-point number is D, and a value of D ranges from 0 to 4 bits.

For example, the first exponent field Es represents the exponent of the floating-point number. It is assumed that a value range of the exponent of the floating-point number is E, and a value Ev represented by the first exponent field Es belongs to the value range E. The value range E may be determined according to the following Formula 1: $E = {\left(-1\right)}^{Se} \times \left[{2}^{D - 1}, \left({2}^{D}-1\right)\right]$ Formula 1

Se is a sign bit of the value Ev, and may also be referred to as an exponent sign bit of the floating-point number. Se occupies 1 bit in the bit width D of the exponent field, and indicates that the value of the first exponent field is positive or negative. In an embodiment, Se being 0 indicates that the value Ev is positive, and Se being 1 indicates that the value Ev is negative. In another embodiment, Se being 0 may alternatively indicate that the value Ev is positive, and Se being 1 indicates that the value Ev is negative. This is not specifically limited in this application.

With reference to Formula 1 and Table 3, when the bit width D of the first exponent field is 0, the value Ev represented by the first exponent field is 0, that is, the value range E of the exponent of the floating-point number is 0. When the bit width D of the first exponent field is 1, the value Ev represented by the first exponent field may be 1 or -1, that is, the value range E of the exponent of the floating-point number is ±1. When the bit width D of the first exponent field is 2 to 4, the value Ev represented by the first exponent field may be any value in [-2, -15] or [2, 15], that is, the value range E of the exponent of the floating-point number is ±[2, 15]. It can be learned that the value range E of the exponent of the floating-point number that can be represented by the first exponent field is [-15, 15].

In an optional embodiment, when the bit width D is 0 and not DML, it indicates that the exponent of the floating-point number is 0. When the bit width D is not 0, that is, the bit width D is any value ranging from 1 to 4, the first exponent field may be coded through signed magnitude (signed magnitude) coding, which may also be referred to as a coding scheme in which the sign bit Se follows an original code. In this representation, the sign bit is added before a value, that is, the most significant bit of the original code is the sign bit, indicating that the value is positive or negative. A sign bit being 0 indicates positive, and a sign bit of 1 indicates negative. Bits other than the sign bit in the original code represent a magnitude of the value, that is, a magnitude of the original code. For example, the original code 1001 represents -1, and 0011 represents +3.

In this embodiment of this application, when the bit width D is not 0, the first exponent field in the floating-point number may use a coding scheme in which the exponent sign bit Se follows the magnitude of the original code, and may be represented as Es:{Se+Mag[2:end]}. The exponent sign bit Se is a sign bit extracted from the initial original code, and indicates that the value of the first exponent field is positive or negative; Mag indicates a magnitude of the value of the first exponent field, end=D-1, and Mag[2:end] indicates values of the second bit to the (D-1)^{th} bit of the first exponent field. For different bit widths D, the most significant bit b1 of the magnitude Mag of the value of the first exponent field is always 1 (that is, 1'b1). Therefore, the most significant bit 1'b1 may not occupy a bit width during encoding, that is, the most significant bit 1'b1 is hidden and is not actually stored. During subsequent decoding, the most significant bit 1'b1 may be directly added to obtain a coded value Ei of the exponent field in the normalized floating-point number: {Se+1'b1+Mag[2:end]}. The normalized floating-point number indicates a floating-point number that complies with the IEEE 754 binary floating-point number standard, and the normalized floating-point number can be used for floating-point number computation. Because the most significant bit of the coded value Ei of the exponent field does not need to occupy a bit width in the first exponent field and is not actually stored, storage space can be greatly saved, and data storage and data transfer costs can be reduced.

For example, as shown in Table 5, when the Dot field is a DML flag, it indicates that the floating-point number is DML data. In this case, the bit width of the first mantissa field is 3, that is, the first mantissa field uses 3 bits to represent the bias of the exponent of the floating-point number. When the Dot field indicates that the bit width D of the first exponent field is 0, the code Es of the first exponent field of the floating-point number is None, and the value Ei of the exponent field of the normalized floating-point number obtained through decoding is 0, indicating that the value Ev of the exponent of the floating-point number is 0. In this case, the bit width of the Dot field is 4, and the bit width of the first mantissa field is 3, that is, the first mantissa field uses 3 bits to represent the mantissa of the floating-point number.

When the Dot field indicates that the bit width D of the first exponent field is 1, the code Es of the first exponent field in the floating-point number is {Se}, and the decoded value of the first exponent field, that is, the value Ei of the exponent field of the normalized floating-point number, is {Se, 1}, where 1 is the value of the most significant bit in Mag. As described above, the most significant bit in Mag is always 1. When the bit width D=1, the exponent Ev of the floating-point number represented by the first exponent field may be 1 or -1, that is, a value range of the exponent Ev of the floating-point number may be ±1. In this case, the bit width of the Dot field is 3, and the bit width of the first mantissa field is 3, that is, the first mantissa field uses 3 bits to represent the mantissa of the floating-point number.

When the Dot field indicates that the bit width D of the first exponent field is 2, the code Es of the first exponent field in the floating-point number is {Se, [2]}, where [2] represents a value of the second bit in Mag. The decoded value of the first exponent field is the value Ei of the exponent field of the normalized floating-point number is {Se, 1, [2]}, where 1 is the value of the most significant bit in Mag. When the bit width D=2, the exponent Ev of the floating-point number represented by the first exponent field may be any value in [-2, -3] or [2, 3], that is, the value range of the exponent Ev of the floating-point number may be ±[2, 3]. In this case, the bit width of the Dot field is 2, and the bit width of the first mantissa field is 3, that is, the first mantissa field uses 3 bits to represent the mantissa of the floating-point number.

When the Dot field indicates that the bit width D of the first exponent field is 3, the code Es of the first exponent field in the floating-point number is {Se, [2:3]}, where [2:3] represents values of the second bit and the third bit in Mag. The decoded value of the first exponent field is the value Ei of the exponent field of the normalized floating-point number is {Se, 1, [2:3]}, where 1 is the value of the most significant bit in Mag. When the bit width D=3, the exponent Ev of the floating-point number represented by the first exponent field may be any value in [-4, - 7] or [4, 7], that is, the value range of the exponent Ev of the floating-point number may be ±[4, 7]. In this case, the bit width of the Dot field is 2, and the bit width of the first mantissa field is 2, that is, the first mantissa field uses 2 bits to represent the mantissa of the floating-point number.

When the Dot field indicates that the bit width D of the first exponent field is 4, the code Es of the first exponent field in the floating-point number is {Se, [2:4]}, where [2:4] represents values of the second bit, the third bit, and the fourth bit in Mag. The decoded value of the first exponent field is the value Ei of the exponent field of the normalized floating-point number is {Se, 1, [2:4]}, where 1 is the value of the most significant bit in Mag. When the bit width D=4, the exponent Ev of the floating-point number represented by the first exponent field may be any value in [-8, -15] or [8, 15], that is, the value range of the exponent Ev of the floating-point number may be ±[8, 15]. In this case, the bit width of the Dot field is 2, and the bit width of the first mantissa field is 1, that is, the first mantissa field uses 1 bit to represent the mantissa of the floating-point number.

It can be seen that, when D is greater than 1, the code Es of the first exponent field in the floating-point number is {Se+Mag[2:end]}, where Mag[2:end] includes bits other than the most significant bit 1'b1 in Mag, and a bit width occupied by Mag[2:end] in the first exponent field is D-1.

**Table 5**

| D | DML | 0 | 1 | 2 | 3 | 4 |
|---|---|---|---|---|---|---|
| Es | / | None | Se | Se, [2] | Se, [2:3] | Se, [2:4] |
| Ei | / | 0 | Se, 1 | Se, 1, [2] | Se, 1, [2:3] | Se, 1, [2:4] |
| Ev | / | 0 | ±1 | ±[2, 3] | ±[4, 7] | ±[8, 15] |
| Bit width of the first mantissa field | 3 | 3 | 3 | 3 | 2 | 1 |

4. First mantissa field: represents the mantissa of the floating-point number, or the bias of the exponent of the floating-point number. The bit width occupied by the first mantissa field in the floating-point number is (N-1-DW-D) bits. For example, the Dot field indicates that the first mantissa field represents the mantissa of the floating-point number or the bias of the exponent of the floating-point number. In some embodiments, when the bit width DW of the Dot field is 4 and the value of the Dot field is "0001", it indicates that the first mantissa field represents the mantissa of the floating-point number; or when the bit width DW of the Dot field is 4 and the value of the Dot field is "0000", it indicates that the first mantissa field represents the bias of the exponent of the floating-point number. In some other embodiments, an opposite setting may also be used. When the bit width DW of the Dot field is 4 and the value of the Dot field is "0000", it indicates that the first mantissa field represents the mantissa of the floating-point number. When the bit width DW of the Dot field is 4 and the value of the Dot field is "0001", it indicates that the first mantissa field represents the bias of the exponent of the floating-point number.

When the first mantissa field represents the mantissa of the floating-point number, the first mantissa field is used to store a value after a decimal point. For example, if decimal places of 1.xxx are stored, it is assumed that the integer place 1'b1 is hidden. For example, if code stored in the first mantissa field is 10011, a decoded value M of the first mantissa field is 0.10011, and a value represented by the first mantissa field is 1.M, that is, 1.10011.

As shown in Table 3, when the first mantissa field represents the bias of the exponent of the floating-point number, the bit width of the first mantissa field is 3, that is, the first mantissa field uses 3 bits to encode an integer value M ranging from 0 to 7, to represent an exponent value of M-23, where M may be referred to as the bias of the exponent. It can be learned that the first mantissa field can further represent a value range [-23, -16] of the exponent. When all the 3 bits of the first mantissa field are 0, that is, M=0, and M-23=-23, the floating-point number represents a special value (which will be described in detail below). Therefore, the first mantissa field may represent a value range [-22, -16] of the exponent. After being combined with the first exponent field (as shown in Table 5), the HiF8_DML floating-point number provided in this embodiment of this application may represent an exponent range of [-22, 15] of the floating-point number. When the exponent of the floating-point number represented by HiF8_DML is 15, a value X of the floating-point number is the largest, and may be approximately Xₘₐₓ₋ₚₒₛ=2¹⁵=32768. When the exponent of the floating-point number represented by HiF8_DML is -22, a value X of the floating-point number is the smallest, and may be approximately Xₘᵢₙ₋ₚₒₛ=2⁻²²≈2.38×10⁻⁷.

When the first mantissa field represents the bias of the exponent of the floating-point number, the corresponding floating-point number is DML data, and the value X of the floating-point number may be represented as: $X = {\left(-1\right)}^{s} \times {2}^{M - 23}$

S is a value of the sign field of the floating-point number, and M is a value represented by the first mantissa field of the floating-point number. In this case, the mantissa of the floating-point number uses the default value 1.

When the first mantissa field represents the mantissa of the floating-point number, the corresponding floating-point number is normal data, and the value X of the floating-point number may be represented as: $X = {\left(-1\right)}^{s} \times {2}^{Ev} \times 1 . M$

S is a value of the sign field of the floating-point number, and Ev is a value represented by the first exponent field of the floating-point number, that is, the exponent of the floating-point number. M is a value represented by the first mantissa field of the floating-point number, and 1.M is the mantissa of the floating-point number. The 1 in 1.M is also considered as a significant bit. It can be learned that a quantity of significant bits of the mantissa of the floating-point number is the bit width of the first mantissa field plus 1.

In conclusion, the value X of the floating-point number may be represented as: $X = \left\{\begin{matrix}{\left(-1\right)}^{s} \times {2}^{E v} \times 1 . M & normal data \\ {\left(-1\right)}^{s} \times {2}^{M - 23} & DML data\end{matrix}\right.$

The HiF8_DML floating-point number provided in this embodiment of this application may further support four special values: 0 (Zero) for which no distinguishing between positive and negative is required, not a number (not a number, NaN), positive infinity (+inf), and negative infinity (-inf). The four special values may be expressed by four boundary values that can be represented by HiF8_DML.
(1) Zero: When the value of the sign field S of the floating-point number is 0 and the Dot field is 0000, that is, the Dot field indicates that the floating-point number is DML data, that is, the first mantissa field represents the bias of the exponent of the floating-point number, and all the 3 bits of the first mantissa field are 0, the corresponding floating-point number may represent ±0, that is, Zero. The foregoing description may be summarized as follows: When HiF8=8'b 0 0000 000, it indicates that the value X=Zero.
(2) NaN: When the value of the sign field S of the floating-point number is 1 and the Dot field is 0000, that is, the Dot field indicates that the floating-point number is DML data, that is, the first mantissa field represents the bias of the exponent of the floating-point number, and all the 3 bits of the first mantissa field are 0, the corresponding floating-point number may represent not a number, that is, NaN. The foregoing description may be summarized as follows: When HiF8=8'b 1 0000 000, it indicates that X=NaN.
(3) Positive infinity: When the bit width of the first exponent field of the floating-point number is 4, the bit width of the first mantissa field is 1, the value of the first exponent field is 0111, and the value of the first mantissa field is 1, if the value of the sign field S of the floating-point number is 0, the corresponding floating-point number may represent +inf. The foregoing description may be summarized as follows: When the first exponent field Es=4'b0111=15 and the first mantissa field M=1'b1, that is, HiF8=8'b 0 11 0111 1, it indicates that X=+inf.
(4) Negative infinity: When the bit width of the first exponent field of the floating-point number is 4, the bit width of the first mantissa field is 1, the value of the first exponent field is 0111, and the value of the first mantissa field is 1, if the value of the sign field S of the floating-point number is 1, the corresponding floating-point number may represent -inf. The foregoing description may be summarized as follows: When the first exponent field Es=4'b0111=15 and the first mantissa field M=1'b1, that is, HiF8=8'b 1 11 0111 1, it indicates that X=-inf.

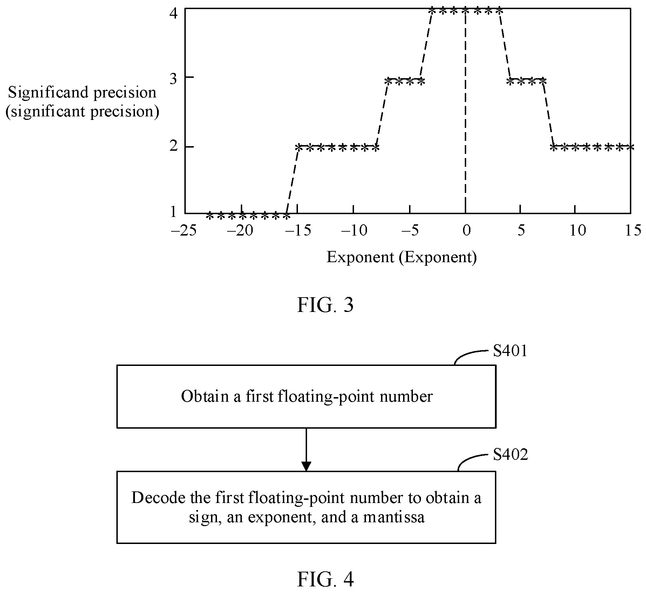

FIG. 3 is a diagram of a distribution of significand precision (significant precision) on an exponent of a HiF8_DML floating-point number according to an embodiment of this application. A magnitude of a significand may represent precision of the floating-point number. When a first mantissa field represents a mantissa of the floating-point number, significant bits of the mantissa may be a bit width of the first mantissa field plus 1. As shown in FIG. 3, HiF8_DML features tapered precision, and can provide precision of up to four significant bits. In addition, HiF8_DML has an exponent range of [-22, 15], which is far greater than the exponent range of [-9, 8] or [-16, 15] of FP8, and is almost equivalent to the exponent range of [-24, 15] of FP16. It can be learned that HiF8_DML can achieve a larger dynamic range of the value represented by the floating-point number. In addition, precision of a value near an exponent center is significantly higher than that far away from the exponent center. For example, when a value of the exponent is [-3, 3], the mantissa has the largest quantity of significant bits, that is, four significant bits. When a value of the exponent is between ±[4, 7], the mantissa has three significant bits. When a value of the exponent is between ±[8, 15], the mantissa has two significant bits. When a value of the exponent is less than -15, the mantissa has one significant bit, and in this case, the mantissa is a default value 1.

The HiF8_DML provided in this embodiment of this application may be used for data storage or data transfer. Correspondingly, an embodiment of this application further provides a floating-point number processing method. The method may be performed by the processor 110 shown in FIG. 2. As shown in FIG. 4, the method may include the following steps.

S401: Obtain a first floating-point number.

The processor may read the first floating-point number from a local memory of a compute device to which the processor belongs, or may obtain the first floating-point number from another compute device over a network. The first floating-point number may include a first sign field, a bit width indication field, a first exponent field, and a first mantissa field. The first sign field indicates a sign of the first floating-point number, that is, indicates that the first floating-point number is positive or negative, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number.

S402: Decode the first floating-point number to obtain the sign, the exponent, and the mantissa.

In some embodiments, the first floating-point number may be decoded to obtain a second floating-point number, where the second floating-point number may include a second sign field, a second exponent field, and a second mantissa field, the second sign field indicates the sign, the second exponent field indicates the exponent, and the second mantissa field indicates the mantissa.

For example, a value of the first sign field of the first floating-point number may be used as a value of the second sign field of the second floating-point number, and the second exponent field and the second mantissa field of the second floating-point number are determined based on values of the first exponent field and the first mantissa field of the first floating-point number.

When the bit width D of the first exponent field is 0, if the bit width indication field indicates that the first mantissa field represents the mantissa of the first floating-point number, a value indicated by the first mantissa field may be used as a value indicated by the second mantissa field of the second floating-point number, and a first preset exponent is used as a value indicated by the second exponent field of the second floating-point number, where the first preset exponent may be -15. If the bit width indication field indicates that the first mantissa field represents the bias of the exponent of the first floating-point number, a preset mantissa may be used as a value indicated by the second mantissa field of the second floating-point number, and a second preset exponent is corrected by using a value of the first mantissa field, to obtain a value of the exponent field of the second floating-point number. The preset mantissa may be 1, and the second preset exponent may be -23.

When the bit width D of the first exponent field is not 0, the first exponent field indicates the exponent of the first floating-point number, and the first mantissa field indicates the mantissa of the first floating-point number. In this case, the first exponent field and the first mantissa field may be determined in the first floating-point number based on the bit width indication field, then the value indicated by the first mantissa field is used as the value indicated by the second mantissa field of the second floating-point number, and the value indicated by the first exponent field is used as the value indicated by the second exponent field of the second floating-point number.

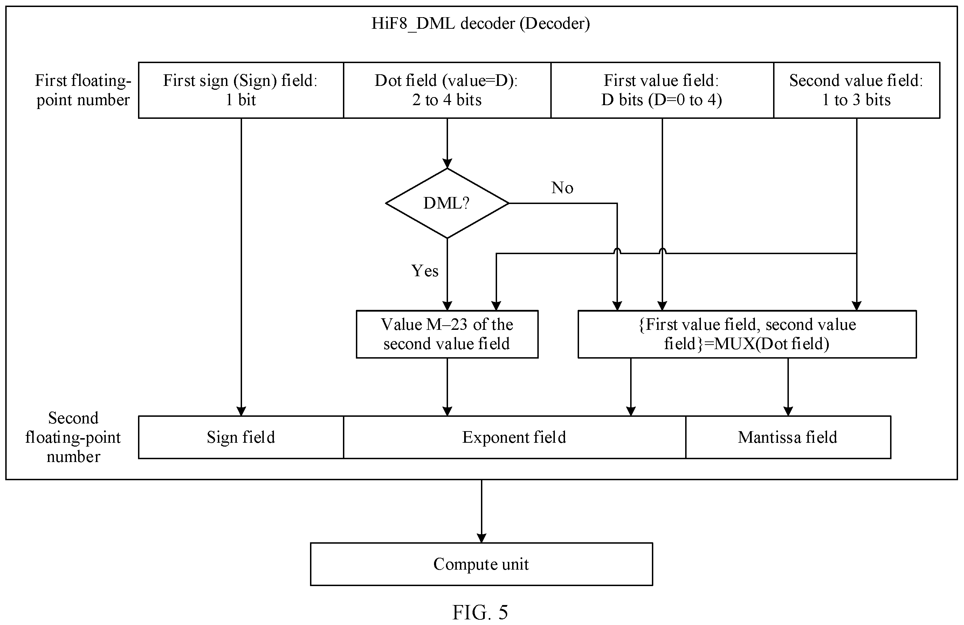

In some embodiments, a decoder in the processor may be configured to convert the first floating-point number into the second floating-point number. For example, a diagram of an operating principle of the decoder may be shown in FIG. 5, and the decoder may also be referred to as a HiF8_DML decoder. As shown in FIG. 5, the first floating-point number sequentially includes a sign field, a Dot field, a first exponent field, and a first mantissa field, and a total bit width N of the first floating-point number is 8. The sign field occupies 1 bit and is the most significant bit in the first floating-point number. The Dot field occupies 2 to 4 bits, the first exponent field occupies 0 to 4 bits, and the first mantissa field occupies 1 to 3 bits. First, for the sign field in the floating-point number, the decoder may directly read and output a value of the sign field, where S=0 or 1. Second, the decoder may determine a bit width of the Dot field based on a value of the second bit, the third bit, or the fourth bit in the first floating-point number. For example, if the value of the second bit in the first floating-point number is "1", it may be determined that the bit width of the Dot field is 2; if the value of the second bit in the first floating-point number is "0" and the value of the third bit is "1", it may be determined that the bit width of the Dot field is still 2; if both the values of the second bit and the third bit in the first floating-point number are "0" and the value of the fourth bit is "1", it may be determined that the bit width of the Dot field is 3; if all the values of the second bit, the third bit, and the fourth bit in the first floating-point number are "0", it may be determined that the bit width of the Dot field is 4.

If the bit width of the Dot field is 4, it may be determined, based on the value of the Dot field, that the first mantissa field represents a mantissa of the first floating-point number or a bias of an exponent of the first floating-point number.

If the first mantissa field represents the mantissa of the first floating-point number, it indicates that the first floating-point number is normal data. The decoder may read a value of the first mantissa field, use the value of the first mantissa field as a value of a second mantissa field of a second floating-point number, and use a first preset exponent as a value of a second exponent field of the second floating-point number. The first preset exponent may be -15.

If the first mantissa field represents the bias of the exponent of the first floating-point number, it indicates that the first floating-point number is DML data. The decoder may read a value of the first mantissa field, and correct a second preset exponent by using the value of the first mantissa field, to obtain a value of an exponent field of the second floating-point number. For example, the second preset exponent may be -23. When the value of the first mantissa field is M, the value of the second exponent field of the second floating-point number may be M-23. The decoder may use a preset mantissa 1 as a value represented by a second mantissa field of the second floating-point number.

If the bit width of the Dot field is 2 or 3, the decoder may extract the Dot field, perform a multiplexer (multiplexer, MUX) operation on the Dot field, and decode the Dot field according to a preset coding rule, to obtain a value D of the Dot field. The preset coding rule may be shown in Table 4 above. The code "11" may represent the value (value) "4", the code "10" may represent the value "3", the code "01" may represent the value "2", and the code "001" may represent the value "1".

The decoder may extract, after the Dot field based on the value D of the Dot field, the first exponent field and the first mantissa field located after the first exponent field, and use a value indicated by the first exponent field as a value indicated by the second exponent field of the second floating-point number; and use a value indicated by the first mantissa field as a value indicated by the second mantissa field of the second floating-point number. In this case, the decoder may determine, based on values of the first exponent field and the first mantissa field and value of the first sign field in the first floating-point number, values of the second exponent field and the second mantissa field and a value of the second sign field of the second floating-point number.

For example, the first floating-point number input to the decoder is "11010110", the total bit width N is 8 bits, the first bit "1" is the sign field, and the second to third bits "10" are the Dot field. According to a preset coding rule, a value of 3 of the Dot field is obtained through decoding, that is, it is determined that a bit width of the first exponent field is 3 bits. Therefore, the decoder can accurately extract the fourth to sixth bits "101" as the first exponent field from the first floating-point number, where the first exponent field represents the exponent of the first floating-point number. The remaining seventh to eighth bits "10" are the first mantissa field, and the first mantissa field represents the mantissa of the first floating-point number. Based on this, it may be obtained through decoding that a value represented by the exponent field of the second floating-point number is 5, and a value represented by the mantissa field of the second floating-point number is 0.10.

In some other embodiments, the first floating-point number may also be decoded to directly obtain the sign, the exponent, and the mantissa. For example, the sign may be determined based on the value of the first sign field of the first floating-point number. For example, if the value of the first sign field is 0, it indicates that the sign is positive; or if the value of the first sign field is 1, it indicates that the sign is negative.

When the bit width D of the first exponent field is 0, it indicates that the first exponent field does not exist. In this case, if the Dot field indicates that the first mantissa field represents the mantissa of the first floating-point number, the exponent may be the first preset exponent -15. If the Dot field indicates that the first mantissa field represents the bias of the exponent of the first floating-point number, the exponent may be a value obtained by correcting the second preset exponent -23 by using the bias, and the mantissa may be the preset mantissa 1.

When the bit width D of the first exponent field is not 0, the mantissa is a value indicated by the first mantissa field of the first floating-point number, and the exponent is the value indicated by the first exponent field of the first floating-point number.

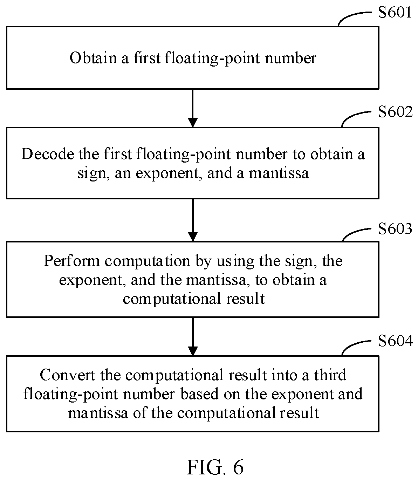

After the sign, the exponent, and the mantissa are obtained, computation may be performed based on the sign, the exponent, and the mantissa. For example, in some other embodiments, as shown in FIG. 6, a floating-point number processing method performed by a processor may include the following steps.

S601: Obtain a first floating-point number.

S602: Decode the first floating-point number to obtain a sign, an exponent, and a mantissa.

S603: Perform computation by using the sign, the exponent, and the mantissa, to obtain a computational result.

In some embodiments, the processor includes a decoder, and the processor may decode the first floating-point number via the decoder, to obtain the sign, the exponent, and the mantissa. The decoder may transmit the sign, the exponent, and the mantissa obtained through decoding to a compute unit in the processor. The compute unit receives the sign, the exponent, and the mantissa, and performs corresponding computation to obtain the computational result. The computational result may be a floating-point number that uses a same coding scheme as a second floating-point number. In other words, the computational result may include a sign field, an exponent field, and a mantissa field. The sign field indicates a sign of the computational result, the exponent field indicates an exponent of the computational result, and the mantissa field indicates a mantissa of the computational result.

S604: Convert the computational result into a third floating-point number based on the exponent and the mantissa of the computational result.

The third floating-point number is a floating-point number that uses a same coding scheme as the first floating-point number, and the third floating-point number may include a first sign field, a Dot field, a first exponent field, and a first mantissa field.

The processor may use the value of the sign field of the computational result as a value of the first sign field of the third floating-point number, and determine, based on the exponent and the mantissa of the computational result, a value range to which the computational result belongs.

If the value range to which the computational result belongs is a first set range, a value of the first mantissa field of the third floating-point number may be determined based on the exponent field and the mantissa field of the computational result, and the Dot field is set to a first value. The first value indicates that the first mantissa field represents a bias of the exponent of the first floating-point number. The first set range indicates a range of DML data.

If the value range to which the computational result belongs is a second set range, values of the first exponent field, the first mantissa field, and the Dot field of the third floating-point number may be respectively determined based on the exponent field and the mantissa field of the computational result. The second set range indicates a range of normal data. If it is determined, based on the exponent field and the mantissa field of the computational result, that the value of the first exponent field is a first preset exponent, that is, a bit width D of the first exponent field is 0, the Dot field may be set to a second value, where the second value indicates that the first mantissa field represents the mantissa of the third floating-point number.

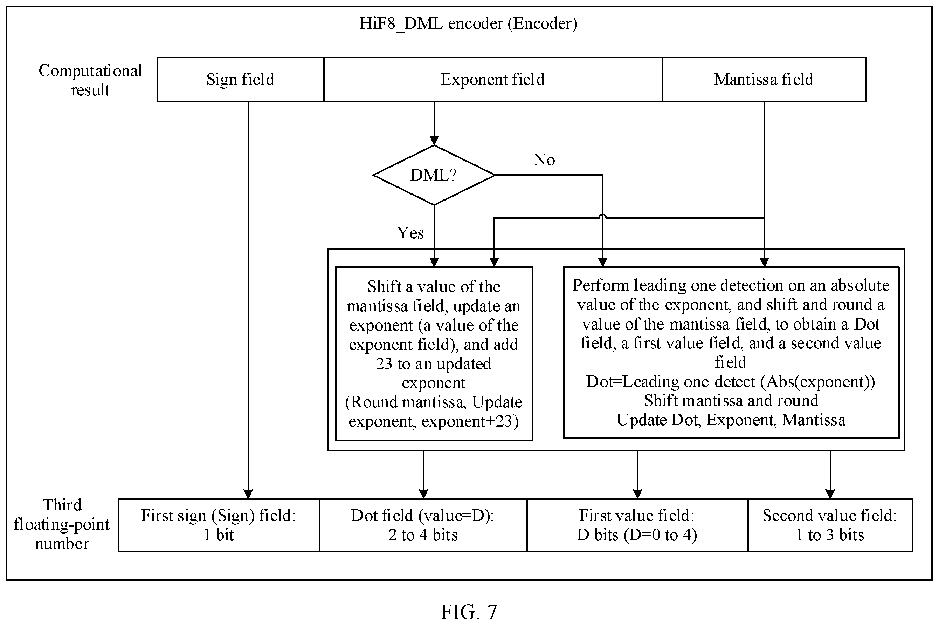

In some embodiments, the processor may further include an encoder. After obtaining the computational result, the compute unit in the processor may transmit the computational result to the encoder, and the encoder converts the computational result into the third floating-point number. The encoder may also be referred to as a HiF8_DML encoder. For example, a diagram of an operating principle of the encoder may be shown in FIG. 7. A computational result may include a sign field, an exponent field, and a mantissa field. The encoder may use a value of the sign field of the computational result as a value of a first sign field of a third floating-point number. The encoder may determine, based on a value of the exponent field in the computational result, a value range to which the computational result belongs.

If the value range to which the computational result belongs is a first set range, that is, the computational result is DML data, the encoder may determine a value of a first mantissa field of the third floating-point number based on an exponent and a mantissa of the computational result. For example, the encoder may process the mantissa of the computational result, adjust the exponent of the computational result based on a processed mantissa, and obtain the first mantissa field of the third floating-point number based on an adjusted exponent. For example, it is assumed that the mantissa of the computational result is 1.XXXXXX, the encoder may perform a mantissa shift and rounding operation on the mantissa of the computational result, and round the mantissa to an integer bit to obtain a processed mantissa 1.0. In this case, a value of the exponent is increased by 1. Therefore, the exponent of the computational result may be adjusted, and the value of the adjusted exponent is increased by 23 to obtain the value of the first mantissa field of the third floating-point number, and the first mantissa field of the third floating-point number is encoded based on the value of the first mantissa field. The encoder may set the Dot field to a first value, where the first value indicates that the first mantissa field represents a bias of the exponent of the third floating-point number.

If the value range to which the computational result belongs is a second set range, that is, the computational result is normal data, the encoder may separately determine a first exponent field and a first mantissa field of the third floating-point number based on an exponent and a mantissa of the computational result, and determine a bit width indication field of the third floating-point number based on the first exponent field. For example, the encoder may process the mantissa of the computational result, adjust the exponent of the computational result based on a processed mantissa, obtain a value of the first mantissa field of the third floating-point number based on the processed mantissa, obtain a value of the first exponent field of the third floating-point number based on an adjusted exponent, determine, based on the value of the first exponent field, a bit width D occupied by the first exponent field, and determine a value of the bit width indication field based on the bit width D occupied by the first exponent field. When the bit width D occupied by the first exponent field is 0, the bit width indication field is set to a second value, where the second value indicates that the first mantissa field represents a mantissa of a first floating-point number. For example, the encoder may perform leading one detection on an absolute value of the exponent in the computational result, and perform operations including shifting and rounding on the mantissa in the computation result, to separately encode the Dot field, the first exponent field, and the first mantissa field of the third floating-point number.

For example, it is assumed that a sign bit of the computational result is 1, the exponent is "00011" (that is, 3), and the mantissa is "1111". The encoder may determine that a sign bit of the third floating-point number is "1". The encoder performs leading one detection on the absolute value "00011" of the exponent until the leading one is found, and may determine that the bit width of the first exponent field of the third floating-point number is 2 bits, and a coded value of the first exponent field is "01", where "0" is an exponent sign bit, indicating that the exponent is positive, and the most significant bit "1" in the exponent magnitude"11" may be hidden and does not occupy a bit width. This has been described above, and details are not described herein again. The encoder may determine, based on the bit width of 2 bits of the first exponent field, that a value represented by the Dot field of the third floating-point number is 2. The encoding rule shown in Table 4 is still used as an example. If the value represented by the Dot field is 2, it may be determined that the coded value corresponding to the Dot field is "01", which occupies a bit width of 2 bits. In this case, a remaining bit width of the first mantissa field that can be encoded is 3 bits. However, the bit width of the mantissa "1111" of the input computational result is greater than the bit width of the first mantissa field of the third floating-point number. Therefore, the mantissa "1111" may be rounded to obtain a mantissa "10.000" including a hidden bit on the left side of the decimal point. In this case, the decimal point in the mantissa "10.000" needs to be shifted one bit to the left to obtain a mantissa "1.0000" including a hidden bit on the left side of the decimal point. Because the decimal point is moved one bit to the left, correspondingly, the exponent needs to be increased by 1 (that is, 3 plus 1 is 4). In other words, a magnitude of the first exponent field is 4, and the corresponding coded value is "100", where the most significant bit "1" in "100" is hidden, a final coded value of the first exponent field is "00", and a final coded value of the first mantissa field is "000". Finally, the third floating-point number obtained through encoding by the encoder is "10100000".

A finally obtained third floating-point number is HiF8_DML data provided in this embodiment of this application, and the third floating-point number may be used for data storage and data transfer, to reduce resources required for data storage or data transfer.

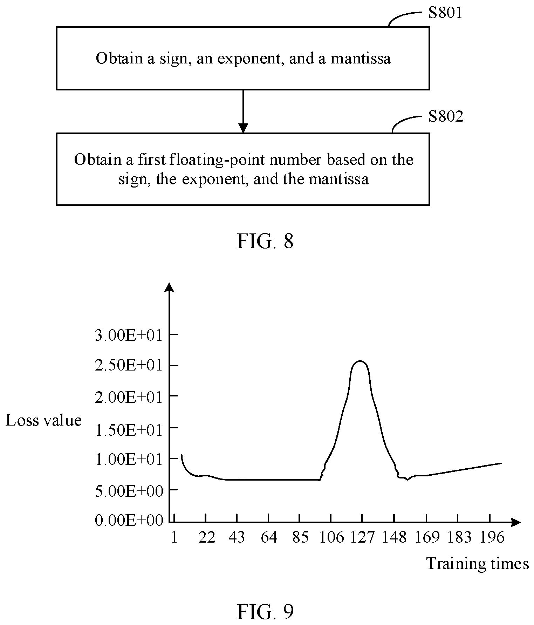

Based on a same inventive concept as the foregoing embodiments, an embodiment of this application further provides a floating-point number processing method, to obtain a first floating-point number used in the foregoing process. As shown in FIG. 8, the method may include the following steps.

S801: Obtain a sign, an exponent, and a mantissa.

S802: Obtain a first floating-point number based on the sign, the exponent, and the mantissa.

For example, the processor may obtain to-be-encoded data, where the to-be-encoded data may be data in another format different from a format of the first floating-point number, or may be an operation result output by a compute unit, and the to-be-encoded data may include the sign, the exponent, and the mantissa. The processor extracts the sign, the exponent, and the mantissa from the to-be-encoded data, and obtains the first floating-point number based on the sign, the exponent, and the mantissa.

For a process in which the processor obtains the first floating-point number based on the sign, the exponent, and the mantissa, refer to the process of obtaining the third floating-point number based on the computational result. Details are not described herein again.

In the floating-point number provided in embodiments of this application, in addition to a sign field, an exponent field, and a mantissa field specified in the standard, a Dot field is added, and the Dot field indicates a significant bit width of a first exponent field of the floating-point number. The bit width is a bit width D occupied by an exponent of the floating-point number during actual storage. In this way, a bit width of the first exponent field in the floating-point number may dynamically change with a value of the Dot field. Accordingly, a bit width of a first mantissa field in the floating-point number also dynamically changes. In this way, the floating-point number features tapered precision, so that data at an exponent center has a higher mantissa bit width, that is, has higher precision, and data farther away from the exponent center has a progressively decreasing mantissa bit width, and lower precision. The exponent of the floating-point number may determine a value range of the floating-point number. Therefore, in embodiments of this application, a total bit width, the value range, and value precision of the floating-point number can be effectively balanced, to satisfy different requirements for the value range and the value precision of the floating-point number in various scenarios, without additionally increasing the total bit width and without additionally increasing data storage or data transfer costs, thereby improving a use effect of the floating-point number.

For example, a floating-point number representation provided in embodiments of this application is applicable to lossy compression of high-precision data and initial approximate solution computation of a mixedprecision matrix solver. For general-purpose computation and high-performance computation, embodiments of this application can achieve a higher compute task convergence speed and higher precision under a same total bit width, that is, under same data storage or data transfer overheads. For AI neural network training and inference, embodiments of this application can satisfy function and accuracy requirements of neural network training and inference under a same total bit width. In embodiments of this application, when a bit width occupied by a first exponent field is 0, 3-bit encoding space is provided for a mantissa. The 3-bit mantissa precision can satisfy the requirements of AI neural network training and inference. Therefore, in embodiments of this application, a bit width of a Dot field is set to 4 bits, where 1 bit indicates that the first mantissa field represents the mantissa or a bias of the exponent. If the first mantissa field represents the bias of the exponent, it indicates that the floating-point number is DML data. When the floating-point number is DML data, the mantissa may be a default value 1, and mantissa precision can satisfy requirements of AI neural network training and inference. In this case, the first mantissa field is used to represent the bias of the exponent, to achieve a larger dynamic range of the exponent, and a larger value range of the floating-point number that can be represented.

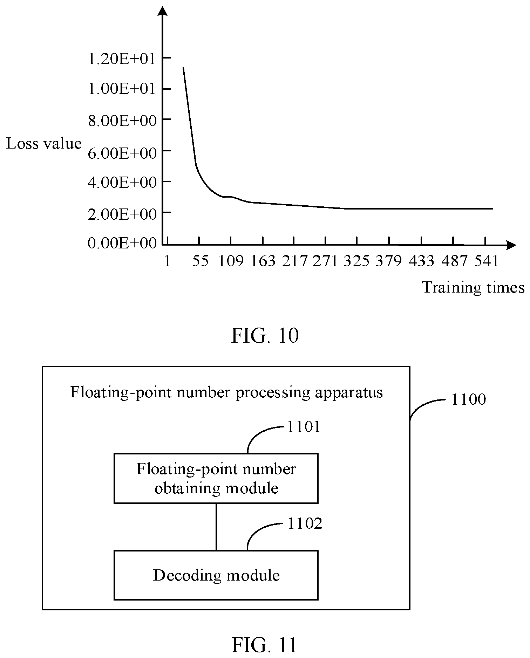

For example, as described above, the floating-point number representation provided in embodiments of this application has a value range of [-22, 15], which is far greater than a value range of [-9, 8] or [-16, 15] of FP8. The value range provided in embodiments of this application can also satisfy the requirements of AI neural network training and inference. For example, for end-to-end training of a large language model (large language model, LLM), as shown in FIG. 9, the conventional floating-point number representation FP8 is used. When end-to-end training is performed on the LLM, because a value range of data that can be represented by a floating-point number is small, when there is a large amount of data with small values, the data cannot be distinguished and is considered as with a same value. As a result, a correct training result cannot be obtained. This is reflected in that when training is performed for more than 100 times, a loss value suddenly increases, training on the LLM breaks down, and convergence cannot be achieved. However, when the floating-point number representation HiF8_DML provided in embodiments of this application is used to perform end-to-end training on the LLM, as shown in FIG. 10, because a value range of data that can be represented by a floating-point number is large, requirements of LLM training can be satisfied. Therefore, training accuracy is improved, and the LLM can be normally converged, thereby improving performance and stability of LLM training.

In conclusion, embodiments of this application can ensure that an impact on value precision of AI neural network training and inference is small, and coding space can be freed up to express DML data, thereby well balancing the value precision and the value range.

In addition, embodiments of this application further define a value range that can be encoded by using an exponent in a first exponent field at different bit widths, and a value range that can be encoded when the first mantissa field represents a bias of the exponent. This effectively avoids a problem that values of exponents overlap at different bit widths, so that in the data coding scheme in embodiments of this application, there is no repeated information and no redundant encoding. Based on this, the most significant bit of the original code magnitude in the first exponent field can be hidden and not stored, to further reduce data storage or data transfer costs of the floating-point number.

Based on a same design concept as the foregoing method embodiments, an embodiment of this application further provides a floating-point number processing apparatus. The floating-point number processing apparatus may be applied to the compute device shown in FIG. 1 or FIG. 2, or may be applied to the decoder 111 shown in FIG. 2. The floating-point number processing apparatus may be configured to implement functions in the foregoing method embodiments, and therefore can achieve beneficial effect in the foregoing method embodiments. As shown in FIG. 11, the floating-point number processing apparatus 1100 may include a floating-point number obtaining module 1101 and a decoding module 1102.

The floating-point number obtaining module 1101 is configured to obtain a first floating-point number, where the first floating-point number includes a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number.

The decoding module 1102 is configured to decode the first floating-point number to obtain the sign, the exponent, and the mantissa.

In some embodiments, the decoding module 1102 may be specifically configured to decode the first floating-point number to obtain a second floating-point number, where the second floating-point number includes a second sign field, a second exponent field, and a second mantissa field, the second sign field indicates the sign, the second exponent field indicates the exponent, and the second mantissa field indicates the mantissa.

In some embodiments, the floating-point number processing apparatus 1100 may further include a compute module, and the compute module may be configured to perform computation by using the sign, the exponent, and the mantissa. In some other embodiments, the compute module may also be located in a compute unit outside the decoder, and the floating-point number processing apparatus 1100 may transmit the sign, the exponent, and the mantissa to the compute unit, and the compute unit performs computation by using the sign, the exponent, and the mantissa.

It should be noted that, in some embodiments, the floating-point number obtaining module 1101 may be configured to perform any step in the floating-point data processing method, and the decoding module 1102 may be configured to perform any step in the floating-point data processing method. Steps to be implemented by the floating-point number obtaining module 1101 and the decoding module 1102 may be specified as required. The floating-point number obtaining module 1101 and the decoding module 1102 separately implement different steps in the floating-point number processing method to implement all functions of the floating-point number processing apparatus.

Functional modules in embodiments of this application may be integrated into one processor, each of the modules may exist alone physically, or two or more modules are integrated into one module. The integrated module may be implemented in a form of hardware, or may be implemented in a form of a software functional unit.

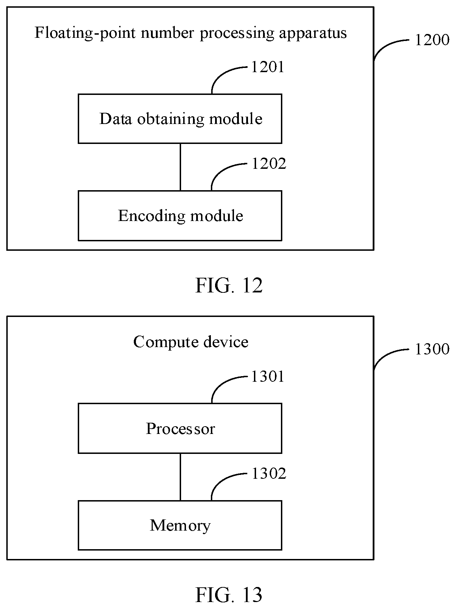

Based on a same design concept as the foregoing method embodiments, an embodiment of this application further provides a floating-point number processing apparatus. The floating-point number processing apparatus may be applied to the compute device shown in FIG. 1 or FIG. 2, or may be applied to the encoder 112 shown in FIG. 2. The floating-point number processing apparatus may be configured to implement functions in the foregoing method embodiments, and therefore can achieve beneficial effect in the foregoing method embodiments. As shown in FIG. 12, the floating-point number processing apparatus 1200 may include a data obtaining module 1201 and an encoding module 1202.

The data obtaining module 1201 may be configured to obtain a sign, an exponent, and a mantissa. The encoding module 1202 may be configured to obtain a first floating-point number based on the sign, the exponent, and the mantissa. The first floating-point number includes a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number.

It should be noted that, in some embodiments, the data obtaining module 1201 may be configured to perform any step in the floating-point data processing method, and the encoding module 1202 may be configured to perform any step in the floating-point data processing method. Steps to be implemented by the data obtaining module 1201 and the encoding module 1202 may be specified as required. The data obtaining module 1201 and the encoding module 1202 separately implement different steps in the floating-point number processing method to implement all functions of the floating-point number processing apparatus.

Functional modules in embodiments of this application may be integrated into one processor, each of the modules may exist alone physically, or two or more modules are integrated into one module. The integrated module may be implemented in a form of hardware, or may be implemented in a form of a software functional unit.

Based on a same technical concept as the foregoing method embodiments, an embodiment of this application further provides a compute device. The compute device may be any compute device shown in FIG. 1 or FIG. 2. The compute device may be configured to implement functions of the method embodiment shown in FIG. 4, FIG. 6, or FIG. 8, and therefore can implement beneficial effect of the foregoing method embodiments.

In some embodiments, a structure of the compute device 1300 may be shown in FIG. 13, and include a processor 1301 and a memory 1302 connected to the processor 1301. The processor 1301 and the memory 1302 may be connected to each other through a bus. The processor 1301 may be a general-purpose processor, for example, a microprocessor, or another conventional processor. The bus may be a peripheral component interconnect (peripheral component interconnect, PCI) bus, an extended industry standard architecture (extended industry standard architecture, EISA) bus, or the like. Buses may be classified into an address bus, a data bus, a control bus, and the like.

The memory 1302 may be configured to store a software program and a module. The processor 1301 runs the software program and the module that are stored in the memory 1302, to perform various functional applications and data processing of the terminal device 1300, for example, any floating-point number processing method provided in embodiments of this application.

The memory 1302 may mainly include a program storage area and a data storage area. The program storage area may store an operating system, an application program of at least one application, and the like. The data storage area may be for storing user data, and the like. In addition, the memory 1302 may include a high-speed random access memory, and may further include a non-volatile memory such as at least one disk storage device, a flash memory device, or another volatile solid-state storage device.

The processor 1301 in the compute device 1300 is configured to run computer instructions or the program stored in the memory 1302, to perform a function in any one of the foregoing method embodiments. In some embodiments, the processor 1301 may include one or more processing units, and different processing units may be independent devices, or may be integrated into one or more processors. The processor 1301 may further include a controller. The controller may generate an operation control signal based on instruction operation code and a time sequence signal, to complete control of instruction fetching and instruction execution.

In some embodiments, the processor 1301 of the compute device 1300 may include a decoder, and the processor 1301 may be configured to implement the floating-point number processing method shown in FIG. 4. In some other embodiments, the processor 1301 of the compute device 1300 may include an encoder, and the processor 1301 may be configured to implement the floating-point number processing method shown in FIG. 8. Alternatively, in some other embodiments, the processor 1301 of the compute device 1300 may include a decoder and an encoder, and the processor 1301 may be configured to implement the floating-point number processing method shown in FIG. 6.

In an embodiment, the compute device 1300 may further include a communication module, and the communication module may be configured to communicate with a network device.

It can be understood that, a structure illustrated in embodiments of this application does not constitute a specific limitation on the terminal device. In some other embodiments of this application, the terminal device may include more or fewer components than those shown in the figure, or some components may be combined, some components may be split, or different component arrangements may be used. The components shown in the figure may be implemented by hardware, software, or a combination of software and hardware.

An embodiment of this application further provides a computer program product, including computer-executable instructions. In an embodiment, the computer-executable instructions are used to enable a computer to perform functions in the foregoing method embodiments.

The computer-executable instructions may be stored in a computer-readable storage medium. An embodiment of this application further provides a computer-readable storage medium. The computer-readable storage medium stores executable instructions. In an embodiment, the computer-executable instructions are used to enable a computer to perform functions in the foregoing method embodiments.

The computer-readable storage medium provided in this embodiment of this application may be a random access memory (random access memory, RAM), a flash memory, a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), a register, a hard disk drive, a removable hard disk, a CD-ROM, or any other form of computer-readable storage medium well-known in the art.

The computer-executable instructions may be stored in the computer-readable storage medium, or may be transmitted from a computer-readable storage medium to another computer-readable storage medium. For example, a computer program or the instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape, or may be an optical medium, for example, a digital video disc (digital video disc, DVD), or may be a semiconductor medium, for example, a solid-state drive.

In embodiments of this application, unless otherwise stated or if there is a logic conflict, terms and/or descriptions in different embodiments are consistent and may be mutually referenced, and technical features in different embodiments may be combined into a new embodiment based on an internal logical relationship thereof. In addition, the terms "include", "have", or any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device.

Although this application is described with reference to specific features and embodiments thereof, it is clear that various modifications and combinations may be made to them without departing from the spirit and scope of this application. Correspondingly, this specification and the accompanying drawings are merely example descriptions of solutions defined by the appended claims, and are considered as any or all of modifications, variations, combinations, or equivalents that fall within the scope of this application.

It is clear that a person skilled in the art can make various modifications and variations to this application without departing from the scope of this application. This application is intended to cover these modifications and variations of embodiments of this application provided that they fall within the scope of the claims of this application and their equivalent technologies.

## Claims

1. A floating-point number processing method, wherein the method comprises:
obtaining a first floating-point number, wherein the first floating-point number comprises a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number; and
decoding the first floating-point number to obtain the sign, the exponent, and the mantissa.

2. The method according to claim 1, wherein decoding the first floating-point number to obtain the sign, the exponent, and the mantissa comprises:
decoding the first floating-point number to obtain a second floating-point number, wherein the second floating-point number comprises a second sign field, a second exponent field, and a second mantissa field, the second sign field indicates the sign, the second exponent field indicates the exponent, and the second mantissa field indicates the mantissa.

3. The method according to claim 1 or 2, wherein when the bit width D is 0, the first exponent field does not exist, and if the first mantissa field represents the mantissa, the exponent is a first preset exponent.

4. The method according to any one of claims 1 to 3, wherein when the bit width D is 0, the first exponent field does not exist, and if the first mantissa field represents the bias, the mantissa is a preset mantissa, and the exponent is a value obtained by correcting a second preset exponent by using the bias.

5. The method according to any one of claims 1 to 4, wherein when the bit width D is not 0, the first mantissa field represents the mantissa, and the exponent is a value indicated by the first exponent field.

6. The method according to any one of claims 1 to 5, wherein a bit width DW of the bit width indication field is negatively correlated with the bit width D.

7. The method according to any one of claims 1 to 6, wherein when the bit width DW of the bit width indication field is a preset bit width, and a value indicated by the bit width indication field is a preset value, the first mantissa field represents the bias.

8. The method according to any one of claims 1 to 7, wherein obtaining the first floating-point number comprises:
reading the first floating-point number from a memory, or obtaining the first floating-point number over a communication network.

9. The method according to any one of claims 1 to 8, wherein the method further comprises:
performing computation by using the sign, the exponent, and the mantissa.

10. A floating-point number processing method, wherein the method comprises:
obtaining a sign, an exponent, and a mantissa; and
obtaining a first floating-point number based on the sign, the exponent, and the mantissa, wherein the first floating-point number comprises a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number.

11. The method according to claim 10, wherein when the bit width D is 0, the first exponent field does not exist, and if the first mantissa field represents the mantissa, the exponent is a first preset exponent.

12. The method according to claim 10 or 11, wherein when the bit width D is 0, the first exponent field does not exist, and if the first mantissa field represents the bias, the mantissa is a preset mantissa, and the exponent is a value obtained by correcting a second preset exponent by using the bias.

13. The method according to any one of claims 10 to 12, wherein when the bit width D is not 0, the first mantissa field represents the mantissa, and the exponent is a value indicated by the first exponent field.

14. The method according to any one of claims 10 to 13, wherein a bit width DW of the bit width indication field is negatively correlated with the bit width D.

15. The method according to any one of claims 10 to 14, wherein when the bit width DW of the bit width indication field is a preset bit width, and a value indicated by the bit width indication field is a preset value, the first mantissa field represents the bias.

16. A floating-point number processing apparatus, wherein the apparatus comprises:
a floating-point number obtaining module, configured to obtain a first floating-point number, wherein the first floating-point number comprises a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number; and
a decoding module, configured to decode the first floating-point number to obtain the sign, the exponent, and the mantissa.

17. The apparatus according to claim 16, wherein the decoding module is specifically configured to:
decode the first floating-point number to obtain a second floating-point number, wherein the second floating-point number comprises a second sign field, a second exponent field, and a second mantissa field, the second sign field indicates the sign, the second exponent field indicates the exponent, and the second mantissa field indicates the mantissa.

18. A floating-point number processing apparatus, wherein the apparatus comprises:
a data obtaining module, configured to obtain a sign, an exponent, and a mantissa; and
an encoding module, configured to obtain a first floating-point number based on the sign, the exponent, and the mantissa, wherein the first floating-point number comprises a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number.

19. The apparatus according to claim 18, wherein when the bit width D is 0, the first exponent field does not exist, and if the first mantissa field represents the bias, the mantissa is a preset mantissa, and the exponent is a value obtained by correcting a second preset exponent by using the bias.

20. A compute device, comprising a processor and a memory, wherein
the memory stores a computer program; and
the processor is configured to read the computer program stored in the memory and perform the following steps:
obtaining a first floating-point number, wherein the first floating-point number comprises a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number; and
decoding the first floating-point number to obtain the sign, the exponent, and the mantissa.

21. The compute device according to claim 20, wherein the processor is specifically configured to:
decode the first floating-point number to obtain a second floating-point number, wherein the second floating-point number comprises a second sign field, a second exponent field, and a second mantissa field, the second sign field indicates the sign, the second exponent field indicates the exponent, and the second mantissa field indicates the mantissa.

22. A compute device, comprising a processor and a memory, wherein
the memory stores a computer program; and
the processor is configured to read the computer program stored in the memory and perform the following steps:
obtaining a sign, an exponent, and a mantissa; and
obtaining a first floating-point number based on the sign, the exponent, and the mantissa, wherein the first floating-point number comprises a first sign field, a bit width indication field, a first exponent field, and a first mantissa field; the first sign field indicates a sign of the first floating-point number, and the bit width indication field indicates a bit width D occupied by the first exponent field in a total bit width N of the first floating-point number; and the bit width indication field further indicates that the first mantissa field represents a mantissa of the first floating-point number or a bias of an exponent of the first floating-point number.

23. The compute device according to claim 22, wherein when the bit width D is 0, the first exponent field does not exist, and if the first mantissa field represents the bias, the mantissa is a preset mantissa, and the exponent is a value obtained by correcting a second preset exponent by using the bias.

24. A computer-readable storage medium, storing computer-executable instructions, wherein the computer-executable instructions are used to enable a computer to perform the method according to any one of claims 1 to 9 or the method according to any one of claims 10 to 15.

25. A computer program product, comprising computer-executable instructions, wherein the computer-executable instructions are used to enable a computer to perform the method according to any one of claims 1 to 9 or the method according to any one of claims 10 to 15.
